# EUROPEAN PATENT APPLICATION

(11) **EP 1 739 744 A2**
(43) Date of publication of application: **03.01.2007**
(21) Application number: 06253356.7
(22) Date of filing: 28.06.2006
(51) Int. Cl.: H01L 23/373

(54) **Heat radiation member and production method for the same**

(30) Priority: 30.06.2005 JP 2005192436
(71) Applicant: POLYMATECH CO., LTD., Tokyo 103-8424 (JP)
(72) Inventor: Ohta, Mitsuru c/o Polymatech Co. Ltd.,, Tokyo 114-0014 (JP); Yamazaki, Jun c/o Polymatech Co. Ltd.,, Tokyo 114-0014 (JP); Tobita, Masayuki c/o Polymatech Co. Ltd.,, Tokyo 114-0014 (JP)
(74) Representative: Sherrard-Smith, Hugh

(57) **Abstract**

A heat radiation member (10, 20) including a thermal diffusion sheet (1); and a thermally conductive polymer layer (2) provided on at least a part of the thermal diffusion sheet (1). Thermal conductivity of the thermally conductive polymer layer (2) in a thickness direction of the layer (2) is higher than thermal conductivity of the thermally conductive polymer layer (2) in a direction parallel to the surface of the layer (2). The heat radiation member (10, 20) is formed by joining an independently formed thermally conductive layer (2) including a thermally conductive filler (3, 4) onto the thermal diffusion sheet (1). The thermally conductive filler (3, 4) are oriented in a specific direction. Alternatively, the heat radiation member (10, 20) is formed by placing a thermally conductive polymer composition containing a thermal conductive filler containing a thermally conductive filler (3, 4) onto the thermal diffusion sheet (1), orienting the thermally conductive filler (3, 4) in a specific direction, and curing the thermally conductive polymer composition while the orientation is maintained.

## Description

The present invention relates to a heat radiation member for radiating heat generated from semiconductor devices and electronic parts, and to a production method for the same.

Up to now, in electronic equipment, heat generated from exothermic parts such as semiconductor devices and electronic parts mounted on a circuit board is transmitted to a cooling member such as a heat sink or a cooling fan to be radiated. To this end, a flexible thermally conductive sheet containing a thermally conductive filler, thermally conductive grease, a thermally conductive adhesive, or a thermally conductive phase changing material has been used at an interface between those exothermic parts and the cooling member. Along with achieving sophisticated functions, higher performance, downsizing, and thinning in final products, space for installing a substrate including exothermic parts thereon is becoming narrower in the equipment. Therefore, in recent years, use of a thermal diffusion sheet made of graphite or metal for diffusing heat along a surface thereof is becoming popular to efficiently diffuse the generated heat in the limited narrow space.

However, a thermal diffusion sheet made of graphite or metal cannot be placed in direct contact with exothermic parts with satisfactory adhesion therebetween, because the graphite sheet or metal sheet has poor conformity to the exothermic parts due to high stiffness thereof. As a result, the expected effect of excellent thermal conduction properties of the sheet may not be obtained. Therefore, there is proposed a heat radiation member including a flexible sheet made of a thermally conductive polymer material, which is formed on at least one side of a thermal diffusion sheet such as a graphite sheet or a metal sheet having high stiffness.

Japanese Laid-Open Patent Publications No.2003-168882 and No.2005-57088 each disclose a double-layer or triple-layer thermally conductive sheet including a soft thermally conductive layer which is formed on at least one side of a graphite sheet or the like. Japanese Laid-Open Patent Publication No.2004-243650 discloses a thermally conductive sheet including a thermally conductive silicone elastomer layer which is formed on a graphite sheet through a specific polymer layer to improve tackiness, adhesion, and repairability. Japanese Laid-Open Patent Publication No.11-340673 discloses a similar thermally conductive electromagnetic shield sheet provided with electromagnetic shielding properties.

Meanwhile, in a recent application area of electronic equipment in which the amount of heat generation is increasing, even when the above-mentioned heat radiation member is used, the reduction in contact heat resistance is unsatisfactory. Thus, Japanese Laid-Open Patent Publication No.2003-158393 proposes a heat radiation structure including a specific phase changing thermally conductive material layer formed on a graphite sheet, in which said layer softens or melts at high temperature. However, in the thermally conductive material layer made of a phase changing material, handling ease in actual use is unsatisfactory as compared with a conventional solid thermally conductive material layer made of an elastomer-based material. Further, because the thermally conductive material layer made of a phase changing material softens or melts when it is exposed to high temperature, the thermally conductive layer may shrink and dislocate with respect to exothermic parts. This may reduce thermal conductivity of the layer. In addition, the thermally conductive material made of a phase changing material softens or melts to adhere to the exothermic parts. Therefore, the thermally conductive material made of the phase changing material has poor repairability. Herein, the term of "repairability" refers to a property of being able to be detached from the exothermic parts and relocated for correcting dislocation/mislocation. Therefore, the application field for such thermally conductive layers is limited to a narrow range. Consequently, a heat radiation member is strongly desired, which can effectively transmit the heat from semiconductor devices and electronic parts to a thermal diffusion sheet, and has excellent handling ease at the time of mounting, as well as high repairability and sufficient adhesion with the heat radiation part and exothermic parts for preventing dislocation with respect to them.

The present invention has been made in view of the above-mentioned problems. It is an object of the present invention to provide a heat radiation member for effectively transmitting and diffusing heat from exothermic parts mounted on electronic equipment, and a production method for the same.

In one aspect, the present invention provides a heat radiation member including a thermal diffusion sheet and a thermally conductive polymer layer provided on at least a part of the thermal diffusion sheet. Thermal conductivity of the thermally conductive polymer layer in a thickness direction of the layer is higher than thermal conductivity of the thermally conductive polymer layer in a direction parallel to the surface of the layer.

The present invention also provides a method for producing a heat radiation member including a thermal diffusion sheet and a thermally conductive polymer layer provided on at least a part of the thermal diffusion sheet. In one aspect, the method includes steps of independently forming the thermally conductive layer in a sheet from a thermally conductive polymer composition containing a thermal conductive filler, wherein the thermal conductive filler in the layer is oriented in a specific direction such that thermal conductivity of the thermally conductive polymer layer in a thickness direction of the layer becomes higher than thermal conductivity of the thermally conductive polymer layer in a direction parallel to the surface of the layer; and joining the formed thermally conductive layer onto at least a part of the thermal diffusion sheet.

In another aspect, the method includes steps of placing a thermally conductive polymer composition containing a thermal conductive filler onto at least a part of the thermal diffusion sheet; orienting the thermally conductive filler in a specific direction such that thermal conductivity of the thermally conductive polymer layer to be obtained in a thickness direction of the layer becomes higher than thermal conductivity of the thermally conductive polymer layer in a direction parallel to the surface of the layer; and curing the thermally conductive polymer composition, while the orientation of the thermally conductive filler is maintained, to form the thermally conductive layer on the thermal diffusion sheet.

Other aspects and advantages of the invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a perspective view of a heat radiation member according to a first embodiment;
Fig. 2 is a sectional view of a thermally conductive polymer layer 2 of the heat radiation member of the first embodiment;
Fig. 3 is a perspective view of a heat radiation member according to a second embodiment;
Fig. 4 is a sectional view of the thermally conductive polymer layer 2 of the heat radiation member of the second embodiment; and
Fig. 5 is a schematic diagram of the heat radiation member of the present invention which is used to radiate heat from exothermic parts mounted on a printed circuit board.

Preferred embodiments of the present invention will be described in detail hereinafter.

### (First embodiment)

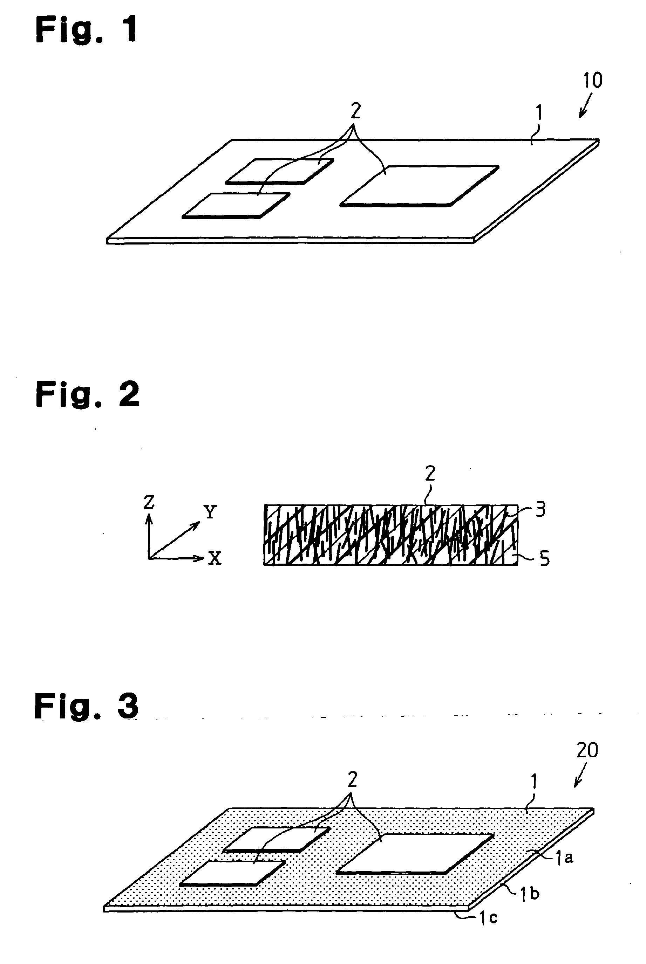

A heat radiation member according to a first embodiment of the present invention will be described with reference to the accompanying drawings. Fig. 1 shows a perspective view of a heat radiation member 10 according to the first embodiment. The heat radiation member 10 includes a thermal diffusion sheet 1 and thermally conductive polymer layers 2 formed on parts of a top surface of the thermal diffusion sheet 1. Preferably, the thermally conductive polymer layers 2 are selectively formed on the thermal diffusion sheet 1. at positions corresponding to exothermic parts which generate heat when in use. In this embodiment, the thermal diffusion sheet 1 is preferably a graphite sheet.

Fig. 2 shows a sectional view of the thermally conductive polymer layer 2. The thermally conductive polymer layer 2 contains a polymer material 5 as a matrix and carbon fibers 3 as a thermally conductive filler. In the thermally conductive polymer layer 2, the carbon fibers 3 are oriented in such a manner that the longitudinal axes of the fibers are aligned along the thickness direction of the thermally conductive polymer layer 2, namely in the Z axis direction shown in Fig. 2. Accordingly, the longitudinal axes of the carbon fibers 3 are substantially perpendicular to the thermal diffusion sheet 1. The carbon fibers 3 have a higher thermal conductivity in the longitudinal axial direction than in the radial direction of the fibers. Therefore, the thermal conductivity of the thermally conductive polymer layer 2 in the thickness direction is set higher than the thermal conductivity of the layer in a direction parallel to the surface thereof. The orientation of the carbon fibers 3 is preferably carried out by an application of a magnetic field thereto.

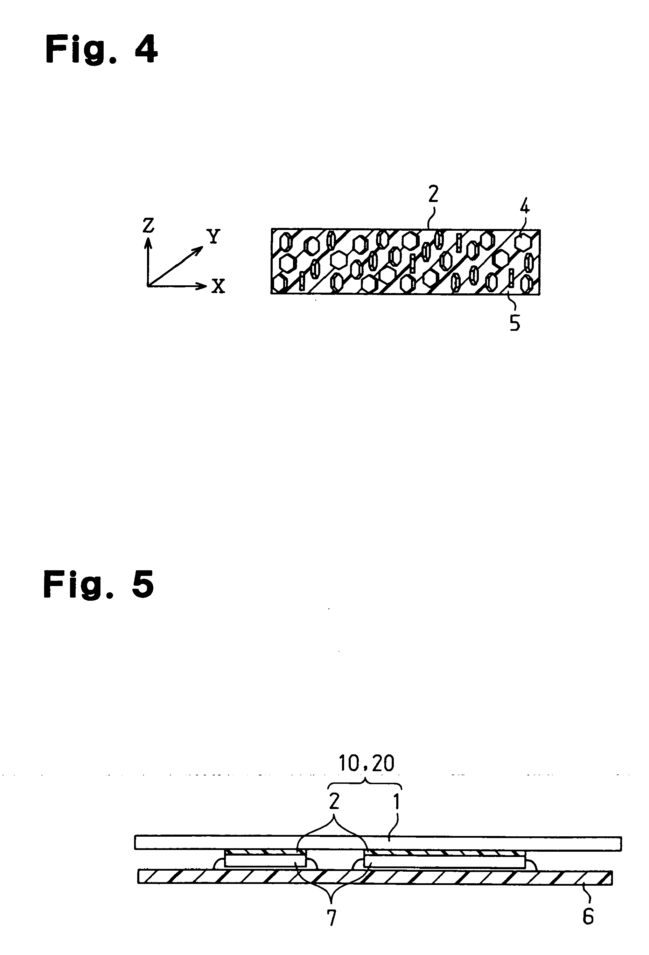

Fig. 5 shows that the heat radiation member 10 is mounted on a printed circuit board 6 having exothermic parts 7 such as semiconductor packages. The heat radiation member 10 is placed on the printed circuit board 6 in such a manner that the thermally conductive polymer layers 2 come into close contact with the exothermic parts 7. As a result, the heat generated from the exothermic parts 7 is effectively transmitted to the thermal diffusion sheet 1 through the thermally conductive polymer layers 2, diffused into the thermal diffusion sheet 1 in a direction parallel to the surface of the sheet, and further radiated to the outside of the sheet from the periphery and surface of the thermal diffusion sheet 1.

In the first embodiment, the thermal conductivity of the thermally conductive polymer layer 2 in the thickness direction is higher than the thermal conductivity of the layer in a direction parallel to the surface thereof. When the thermally conductive polymer layers 2 are arranged to be in contact with the exothermic parts 7 for use, the direction of the conduction of the heat from the exothermic parts 7 corresponds to the thickness direction of the thermally conductive polymer layers 2. Therefore, the thermally conductive polymer layers 2 can rapidly and efficiently conduct the heat from the exothermic parts 7 to the thermal diffusion sheet 1.

In the first embodiment, the carbon fibers 3 having higher thermal conductivity in the longitudinal axial direction than in the radial direction of the fibers is used as the thermally conductive filler. Since orientation of the carbon fibers 3 can be easily controlled by application of a magnetic field thereto due to their magnetic anisotropy, the carbon fibers 3 can be highly oriented in such a manner that the longitudinal axes of the carbon fibers 3 are aligned along the thickness direction of the thermally conductive polymer layer 2. As a result, the thermal conductivity in the thickness direction of the thermally conductive polymer layer 2 can be significantly improved. In this case, the heat characteristics of the thermally conductive polymer layer 2 can be greatly improved by using carbon fibers 3 that have been oriented, as compared with when the same carbon fibers 3 is used without being oriented. As a result, an excellent heat radiation member can be obtained at a low material cost.

A graphite sheet may be used as the thermal diffusion sheet 1 in the first embodiment. In this case, such a thermal diffusion sheet 1 can diffuse the heat in a direction parallel to the surface more rapidly than in the thickness direction, because the graphite sheet has an extremely high thermal conductivity (100 to 800 W/mK) in a direction parallel to the surface than in the thickness direction of the sheet. Accordingly, the thermal diffusion sheet 1 made of a graphite sheet can diffuse the heat transmitted from the thermally conductive polymer layers 2 along the sheet more effectively.

### (Second Embodiment)

A heat radiation member according to a second embodiment of the present invention will be described with reference to Figs. 3 to 5. The heat radiation member 20 shown in Fig. 3 includes the thermal diffusion sheet 1 and the thermally conductive polymer layers 2 formed on the thermal diffusion sheet 1. Preferably, the thermally conductive polymer layers 2 are selectively formed on the thermal diffusion sheet 1 at least at positions corresponding to exothermic parts that generate heat when in use. In this embodiment, the thermal diffusion sheet 1 is preferably a composite sheet consisting of a graphite sheet 1b and aluminum foils 1a and 1c formed on the entire both sides of the graphite sheet 1b. Fig. 4 shows a sectional view of the thermally conductive polymer layer 2. In this embodiment, the thermally conductive polymer layer 2 includes the polymer material 5 as a matrix and hexagonal boron nitride powders 4, which is in the form of scales, as a thermally conductive filler. In the thermally conductive polymer layer 2, the scaly hexagonal boron nitride powders 4 are oriented in such a manner that a direction along the surface of each scale (i.e. a direction substantially parallel to the surface of the scales) corresponds to the thickness direction of the thermally conductive polymer layer 2 as shown in Fig. 4. Accordingly, the direction parallel to the surface of each scale is substantially perpendicular to the surface of the thermal diffusion sheet 1. The scaly hexagonal boron nitride powders have a higher thermal conductivity in a direction parallel to the surface than in the thickness direction of each scale. More specifically, in the scaly hexagonal boron nitride powders, hexagonal boron nitride crystals are regularly oriented in a specific direction in general. When the hexagonal crystal structure is regarded as a hexagonal pillar, the direction parallel to the surface of the scales consists with a direction parallel to the cross section of the hexagonal pillar. The hexagonal boron nitride crystals have more excellent thermal conduction properties in a cross-sectional direction of the hexagonal pillar. Therefore, in the case where the scaly hexagonal boron nitride is oriented in such a manner that the direction along the surface of the scales corresponds to the thickness direction of the thermally conductive polymer layer 2 as shown Fig.4, the thermal conductivity of the thermally conductive polymer layer 2 in the thickness direction is set to be higher than the thermal conductivity in a direction parallel to the surface of the layer. The orientation of the hexagonal boron nitride powders 4 is preferably carried out by an application of a magnetic field thereto.

The heat radiation member 20 of the second embodiment is mounted on the printed circuit board 6 in such a manner that the thermally conductive polymer layers 2 come in close contact with the exothermic parts 7 as shown in Fig. 5 as in the first embodiment. As a result, the heat generated from the exothermic parts 7 is transmitted to the thermal diffusion sheet 1 through the thermally conductive polymer layers 2 and effectively diffused along the thermal diffusion sheet 1.

The heat radiation member 20 according to the second embodiment has the following advantages in addition to those of the first embodiment above-described.

In the second embodiment, the scaly hexagonal boron nitride powders 4 are used as the thermally conductive filler. The orientation of the scaly hexagonal boron nitride powders 4 can be easily controlled by an application of a magnetic field due to their magnetic anisotropy. Therefore, the scaly hexagonal boron nitride powders 4 can be highly oriented in such a manner that a direction parallel to the surface of the scales of the hexagonal boron nitride powders 4 corresponds to the thickness direction of the thermally conductive polymer layer 2. As a result, the thermal conductivity of the thermally conductive polymer layer 2 in the thickness direction of the layer can be improved higher. In this case, the heat characteristics of the thermally conductive polymer layer 2 can be greatly improved by using hexagonal boron nitride powders 4 that have been oriented, as compared with when the same hexagonal boron nitride powders 4 is used without being oriented. As a result, an excellent heat radiation member can be obtained at a low material cost. Further, use of the scaly hexagonal boron nitride powders 4 as thermally conductive filler provides the thermally conductive polymer layer 2 with electric insulating properties. Therefore, the heat radiation member of the second embodiment is extremely useful in any applications where electric insulating properties are required for the thermally conductive polymer layer 2, for example, in the case that the thermally conductive polymer layer 2 may be placed in close contact with electrical terminals of exothermic parts such as a semiconductor device.

In the second embodiment, the composite sheet including aluminum foils 1a and 1c formed on the both sides of the graphite sheet 1b is used as the thermal diffusion sheet 1. The aluminum foils 1a and 1c have excellent isotropic thermal conduction properties. Namely, they have high thermal conductivities not only in a direction parallel to the surface but also in the thickness direction thereof. Therefore, the aluminum foil 1a in close contact with the thermally conductive polymer layers 2 conducts the heat from the thermally conductive polymer layers 2 to the graphite sheet 1b effectively, the graphite sheet 1b diffuses the heat from the thermally conductive polymer layers 2 in a direction parallel to the surface therein. In addition, the aluminum foil 1c formed on the side of the graphite sheet 1b opposing to the aluminum foil 1a can radiate the heat from the graphite sheet 1b to the outside from its surface more efficiently. The mechanical strength and shape retainability of the sheet can be improved by forming aluminum foil layers on the graphite sheet as compared with the graphite sheet alone. In this embodiment, as the entire surface of the graphite sheet is covered with the aluminum foil layers, it is possible to prevent a graphite piece from dropping off the surface of the graphite sheet due to any external force.

Each constituent element of the heat radiation member of the present invention will be described in detail hereafter.

### <Thermal diffusion sheet>

The thermal diffusion sheet 1 diffuses heat in a direction parallel to the surface and further radiating the heat to the outside environment from the periphery and the surface of the sheet. To ensure the thermal diffusion function, the thermal diffusion sheet 1 preferably has a thermal conductivity of 150 to 900 W/mK in a direction parallel to the surface of the sheet. A sheet made of graphite, diamond, a metal such as aluminum, copper, or silver, or any alloys may be used as the thermal diffusion sheet 1. Among of those, a graphite sheet, an aluminum sheet, or a laminated sheet thereof in two or more layers is preferred as the thermal diffusion sheet 1 because each of them has a high thermal conductivity in a direction parallel to the surface of the sheet.

A sheet made of a metal alone such as copper or aluminum has a relatively high thermal conductivity (copper: about 400 W/mK, aluminum: 180 to 200 W/mK). However, the thermal conduction properties of such a sheet are isotropic. When a heat radiation member including a thermal diffusion sheet made of the metal alone is mounted opposed to exothermic parts 7 as shown in Fig. 5, for example, the thermal diffusion sheet diffuses the heat generated from the exothermic parts 7 in a direction parallel to the surface and also efficiently transmits the heat in the thickness direction at portions opposed to the exothermic parts 7. As a result, the temperature of each portion opposed to the respective exothermic part 7 locally rises, thereby producing a so-called heat spot.

In contrast, the graphite sheet has an extremely high thermal conductivity (100 to 800 W/mK) in a direction parallel to the surface of the sheet as compared with the thickness direction. Therefore, the graphite sheet is particularly preferred as the thermal diffusion sheet 1, because the graphite sheet conducts the heat in a direction parallel to the surface more rapidly than in the thickness direction for diffusing the heat, thereby preventing the generation of heat spots. It is also advantageous to use, as the thermal diffusion sheet 1, a composite sheet including a graphite sheet having higher thermally conduction properties in a direction parallel to the surface of the sheet and an aluminum foil layer(s) having excellent isotropic thermal conduction properties. In this case, the aluminum foil layer may be formed on one side or each of the two sides of the graphite sheet. The aluminum foil layer may be formed on the entire surface of the graphite sheet or one part of the surface of the graphite sheet. The aluminum foil 1a formed between the graphite sheet 1b and the thermally conductive polymer layers 2 as shown in Fig. 3 can assist the conduction of the heat from the thermally conductive polymer layers 2 to the graphite sheet. The aluminum foil 1c formed on the side opposite to the thermally conductive polymer layers 2 of the graphite sheet 1b can radiate the heat from the graphite sheet 1b to the outside through the surface thereof.

The thickness of the thermal diffusion sheet 1, which is not particularly limited, is preferably 5 to 500 µm. When the thickness of the thermal diffusion sheet 1 is smaller than 5 µm, the thermal diffusion sheet 1 becomes fragile, easily breaks, and has a small heat capacity disadvantageously. When the thickness of the thermal diffusion sheet 1 is larger than 500 µm, the stiffness of the sheet becomes high, thereby reducing work efficiency. This is not preferred in economical reasons. The thickness of the thermal diffusion sheet 1 is preferably 10 to 400 µm, and more preferably 25 to 200 µm.

### <Thermally conductive polymer layer>

In the thermally conductive polymer layer 2, the thermal conductivity in the thickness direction of the layer is set higher than the thermal conductivity in a direction parallel to the surface of the layer. In a thermally conductive polymer layer included in a similar heat radiation member of the prior art, the thermal conductivity in the thickness direction of the layer may be identical to or lower than the thermal conductivity in a direction parallel to the surface. Therefore, the thermal conduction and thermal diffusion of the heat radiation member of the prior art are unsatisfactory. In the heat radiation member of the present invention, the thermal conductivity in the thickness direction of the thermally conductive polymer layer 2 is set higher than thermal conductivity in a direction parallel to the surface of the layer. This allows the thermally conductive polymer layer 2 to effectively transmit the heat to the thermal diffusion sheet 1. The thermal conductivity in the thickness direction of the thermally conductive polymer layer 2 is preferably set higher than the thermal conductivity in the thickness direction of the thermal diffusion sheet 1. This allows the thermally conductive polymer layer 2 to rapidly transmit heat to the thermal diffusion sheet 1 and to reduce the risk of generating heat spots as above described. The thermally conductive polymer layer 2 may be in solid state in which the polymer material 5 uses a matrix has been completely hardened or cured. Alternatively, the thermally conductive polymer layer 2 may be in uncured semi-cured state in which the polymer material 5 is still uncured or partially cured (also called a "B stage state").

In the case where the thermally conductive polymer layer 2 is uncured or semi-cured, the polymer material 5 is preferably adhesive resin. Adhesive resin used herein means resin which has adhesion to the exothermic parts when it is in uncured or semi-cured state. In mounting process, the thermally conductive polymer layer 2 containing the adhesive resin as the polymer material 5 is placed on an exothermic part to adhere to them, and then fully cured. Therefore, these thermally conductive polymer layers 2 are firmly bonded to the exothermic part without any dislocation during the mounting process and thereby can provide excellent thermal conduction.

In the case where the thermally conductive polymer layer 2 is a solid product, a hardness of the thermally conductive polymer layer 2 is preferably 60 or less. In the present application, the hardness is a value measured by a type A durometer in accordance with Japanese Industrial Standards ("JIS") K6253 (corresponding to ISO 7619-1). When the hardness of the thermally conductive polymer layer 2 is in the above-mentioned range, the thermally conductive polymer layer 2 has sufficiently high flexibility. This thermally conductive polymer layer 2 has excellent handling properties in the mounting process and repairability enabling relocation with respect to an exothermic member. Furthermore, since such flexible thermally conductive polymer layer 2 has good adhesion to the exothermic member, it can provide an excellent thermal conduction. The thermally conductive polymer layer 2 having hardness higher than 60 may have poor adhesion to the exothermic member. The hardness of the thermally conductive polymer layer 2 is more preferably 40 or less, and much more preferably 25 or less.

When the thermally conductive polymer layer 2 is uncured or semi-cured, that is, the polymer material 5 is adhesive resin, the hardness of the thermally conductive polymer layer 2 is not particularly limited.

### <Thermal conductive filler in thermally conductive polymer layer>

The thermally conductive filler contained in the thermally conductive polymer layer 2 may be preferably at least one selected from carbon fibers, carbon nanotubes, metal nitrides, metal oxides, metal carbides and metal hydroxides. Those thermally conductive fillers preferably have anisotropic thermal conduction properties. For example, carbon fibers have higher thermal conduction properties in the axial direction than in the diameter direction of the fiber.

The raw materials for the carbon fibers include fused polycyclic hydrocarbon compounds such as naphthalene and phenanthrene, and fused heterocyclic compounds such as petroleum pitch and coal pitch. Among of those raw materials, petroleum-based pitch and coal-based pitch are preferred, and optically anisotropic pitch, that is, mesophase pitch is particularly preferred. Those raw materials may be used alone or in combination of two or more. It is most preferable to use mesophase pitch alone, that is, carbon fiber containing a mesophase pitch in content of 100 %. The carbon fibers used in the present invention may be in a form of fibrous (including ground or cut products which maintain a fibrous form), whiskers, coils or nanometric tubes, but not to be limited thereto. The fiber diameter of the carbon fibers is preferably 5 to 20 µm, more preferably 5 to 15 µm, and particularly preferably 8 to 12 µm. When the fiber diameter is smaller than 5 µm or larger than 20 µm, the productivity of the carbon fibers lowers disadvantageously. The average length of the carbon fibers is preferably 5 to 500 µm, more preferably 15 to 100 µm, and particularly preferably 15 to 45 µm. When the average length is smaller than 5 µm, contacts between the carbon fibers decrease and cannot provide sufficient heat conduction passages in the thermally conductive polymer layer 2 decrease, thereby reducing the thermal conductivity of the thermally conductive polymer layer 2. When the average length is larger than 500 µm, the carbon fibers become bulky, thereby making it difficult to charge them into the polymer material 5 in a high concentration. The average length value of the carbon fibers can be calculated from a particle size distribution by a laser diffraction system.

The thermal conductivity of the carbon fiber is not particularly limited. However, the thermal conductivity in the longitudinal direction of the carbon fiber is preferably 400 W/mK or more, more preferably 800 W/mK or more, and particularly preferably 1,000 W/mK or more. The carbon fiber may be surface modified by oxidation such as electrolytic oxidation or treatment with a coupling agent or sizing agent. This surface modification may improve wettability to the polymer material 5, or increase the limit of an amount of the carbon fibers that can be mixed into the polymer material 5 or peel strength at the interface with the polymer material 5. Carbon fibers whose surface is coated with a metal or ceramic may also be used. The coating may be performed by physical deposition or chemical deposition such as electroless plating, electrolytic plating, vacuum deposition, sputtering, ion plating, coating, immersion, or mechanochemical method for mechanical fixing of fine particles.

Examples of the metal nitrides include silicon nitride and aluminum nitride, and examples of the metal oxides include aluminum oxide, silicon oxide, zinc oxide, and magnesium oxide. Examples of the metal carbides include silicon carbide, and examples of the metal hydroxides include aluminum hydroxide and magnesium hydroxide. Scaly hexagonal boron nitride is particularly preferred as the thermally conductive filler because it has a higher thermal conductivity in a direction parallel to the surface of the scales than in the thickness direction of the scales.

### <Polymer material in thermally conductive polymer layer>

A description is subsequently given of the polymer material 5 as the matrix material contained in the thermally conductive polymer layer 2. Examples of the polymer material 5 include thermoplastic elastomer forming a solid thermally conductive polymer layer 2, crosslinked rubber, thermoplastic resin, and adhesive resin forming an adhesive (namely in uncured or semi-cured state) thermally conductive polymer layer 2.

Examples of thermoplastic elastomer include styrene-butadiene copolymer, styrene-isoprene block copolymer, hydrogenated product thereof, styrene-based thermoplastic elastomer, olefin-based thermoplastic elastomer, vinylchloride-based thermoplastic elastomer, polyester-based thermoplastic elastomer, polyurethane-based thermoplastic elastomer, and polyamide-based thermoplastic elastomer.

Examples of crosslinked rubber include natural rubber, butadiene rubber, isoprene rubber, styrene-butadiene copolymerization rubber, nitrile rubber, hydrogeneted nitrile rubber, chloroprene rubber, ethylene-propylene copolymerization rubber, chlorinated polyethylene, chlorosulfonated polyethylene, butyl rubber, halogenated butyl rubber, fluororubber, urethane rubber, and silicone rubber.

Examples of thermoplastic resin include polyethylene, polypropylene, ethylene-α-olefin copolymer such as ethylene-propylene copolymer, polymethylpentene, polyvinyl chloride, polyvinylidene chloride, polyvinyl acetate, ethylene-vinyl acetate copolymer, polyvinyl alcohol, polyacetal, fluorine resin such as polyvinylidene fluoride or polytetrafluoroethylene, polyethylene terephthalate, polybutylene terephthalate, polyethylene naphthalate, polystyrene, polyacrylonitrile, styrene-acrylonitrile copolymer, Acrylonitrile Butadiene Styrene (ABS) resin, polyphenylene ether (PPE) resin, modified PPE resin, aliphatic polyamides, aromatic polyamides, polyimide, polyamide imide, polymethacrylates such as polymethacrylate ester such as polymethylmethacrylate, polyacrylic acids, polycarbonate, polyphenylene sulfide, polysulfone, polyether sulfone, polyether nitrile, polyether ketone, polyketone, liquid crystal polymer, and ionomer.

Examples of adhesive resin include epoxy resin, polyimide resin, acrylic resin, bismaleimide, benzocyclobutene, phenol resin, unsaturated polyester resin, diallyl phthalate, silicone resin, polyurethane resin, polyimide silicone resin, thermosetting type PPE resin, and thermosetting type modified PPE resin.

From the viewpoints of flexibility which ensures that the hardness of the cured product becomes 60 or less, basic properties such as heat resistance, temperature characteristics, and electric reliability, the solid thermally conductive polymer layer 2 is preferably formed of at least one selected from silicone rubber, acrylic rubber, olefin-based rubber such as polyisobutylene, and polyurethane. Those polymer materials may be used alone or in combination of two or more. A polymer alloy of two or more polymer materials may also be used. The existence of the crosslinked structure of the polymer material 5 is not particularly limited, and a known crosslinking method such as thermal curing, optical curing, and humidity curing may be employed.

### <Method of producing a heat radiation member>

Alfirst method for producing the heat radiation member of the present invention is characterized in that separately formed thermally conductive polymer layers 2 are joined onto at least one part of the thermal diffusion sheet 1. The thermally conductive polymer layers 2 include a thermally conductive filler which is previously oriented in a specific direction so that its thermal conductivity in the thickness direction becomes higher than its thermal conductivity in a direction parallel to the surface. More specifically, to produce the thermally conductive polymer layers 2, a thermally conductive polymer composition including a polymer material 5 and thermally conductive filler (for example, carbon fibers 3 or hexagonal boron nitride powders 4) is prepared at first. After the thermally conductive polymer composition is independently shaped into a sheet, the thermally conductive filler is oriented in a specific direction so that the thermal conductivity in the thickness direction of the thermally conductive polymer layer 2 to be obtained becomes higher than thermal conductivity in a direction parallel to the surface. While the orientation of the thermally conductive fillers, the thermally conductive polymer composition is hardened or cured to obtain the thermally conductive polymer layer 2. Any numbers of the obtained thermally conductive polymer layers 2 are joined onto the thermal diffusion sheet by any methods including, but not limited to, pressure bonding or thermal fusion. In this way, the heat radiation member of the present invention can be easily produced.

In a second method of producing the heat radiation member of the present invention, a thermally conductive polymer composition containing a thermally conductive filler is placed on at least one part of the thermal diffusion sheet 1. Then, the thermally conductive filler contained in the thermally conductive polymer composition is oriented in a specific direction, and the thermally conductive polymer composition is cured while the orientation is maintained. As a result, the thermally conductive polymer layer 2 having a higher thermal conductivity in the thickness direction than the thermal conductivity in a direction parallel to the surface is formed.

According to the second method, a heat radiation member having a thermally conductive polymer layer 2 in uncured or semi-cured state (B stage state) can be easily produced, as well as the heat radiation member having a solid thermally conductive polymer layer 2. According to the second method, bonding between the thermal diffusion sheet 1 and the thermally conductive polymer layers 2 can be performed by curing bonding by which the uncured or semi-cured thermally conductive polymer layers are fully cured, in addition to pressure bonding and thermal fusing.

In the first and second methods, the orientation of the thermally conductive filler in the thermally conductive polymer layer 2 may be performed by using a flow field, shear field, a magnetic field, or an electric field. In the case where the thermally conductive filler is formed of at least one selected from carbon fibers, carbon nanotubes, metal nitrides, metal oxides, metal carbides and metal hydroxides, it is particularly preferred that the orientation of the thermally conductive filler is performed by an application of a magnetic field or electric field thereto. In this case, owing to a magnetic anisotropy specific to each of those thermally conductive fillers, the thermally conductive filler can be easily and highly oriented in a direction parallel or perpendicular to the lines of magnetic force by externally applying a magnetic field thereto or an electric field to the thermally conductive polymer composition. According to the method using a magnetic field or electric field, the orientation direction of the thermally conductive filler can be controlled to any desired directions.

According to the heat radiation member of the present invention, the thermally conductive polymer layers 2 effectively transmit the heat from the exothermic parts to the thermal diffusion sheet 1 and the thermal diffusion sheet 1 rapidly diffuses the heat in a direction parallel to the surface thereof, thereby radiating the heat effectively. Further, according to the method of producing the heat radiation member of the present invention, the heat radiation member as above-mentioned can be easily obtained.

It should be apparent to those skilled in the art that the present invention can be embodied in many other specific forms without departing from the spirit or scope of the invention. Particularly, it should be understood that the invention may be embodied in the following forms.

In the first embodiment and the second embodiment, the thermally conductive polymer layers 2 may be formed on the entire surface of the thermal diffusion sheet 1.

In the first embodiment and the second embodiment, adhesive layers or pressure sensitive adhesive layers may be formed between the thermally conductive polymer layers 2 and the thermal diffusion sheet 1. Also adhesion between the thermally conductive polymer layers 2 and the thermal diffusion sheet 1 may be improved by treating the surface of the thermal diffusion sheet (ex. corona treatment, ultraviolet treatment and treatment with a coupling agent) in advance.

The following examples and comparative examples are provided for the purpose of further illustrating the present invention but are in no way to be taken as limiting the scope of the invention.

### Examples

### (Example 1)

Firstly, 70 parts by weight of graphitized carbon fibers (produced by Nippon Graphite Fiber Corporation, average fiber diameter: 9 µm, average fiber length: 100 µm) and 150 parts by weight of aluminum oxide powders (produced by Showa Denko K.K., in spherical shape, average particle size: 3.5 µm) ) as thermally conductive fillers were mixed with 100 parts by weight of liquid silicone rubber (produced by GE Toshiba Silicone Co., Ltd.) as a polymer material 5. The resultant mixture was vacuum defoamed to prepare a thermally conductive polymer composition. Subsequently, this thermally conductive polymer composition was injected into a cavity of a mold having a shape corresponding to a predetermined sheet. A magnetic field (magnetic flux density of 10 tesla) was applied in such a manner that the lines of magnetic force corresponded to the thickness direction of the thermally conductive polymer composition in the cavity. Thereby, the graphitized carbon fibers in the thermally conductive polymer composition molded into a sheet were oriented in the thickness direction. While this orientation of the graphitized carbon fibers was maintained, the thermally conductive composition was thermally cured to obtain thermally conductive polymer layer 2 in a sheet having a thickness of 0.15 mm, a length of 10 mm, and a width of 10 mm (hardness of 40). The graphitized carbon fibers contained in the obtained thermally conductive polymer layer 2 were oriented in such a manner that their fiber axes were substantially aligned in the thickness direction of the layer. The thermal conductivities of the thermally conductive polymer layer 2 were measured by a thermal constant measuring instrument (LF/TCM-FA8510B produced by Rigaku Corporation) in accordance with a laser flash method. The thermal conductivities in the thickness direction and the direction parallel to the surface of the thermally conductive polymer layer 2 were 5.7 W/mK and 2.2 W/mK, respectively. This thermally conductive polymer layer 2 was joined onto a thermal diffusion sheet 1 by pressure bonding to produce a heat radiation member 10. The thermal diffusion sheet 1 used was a graphite sheet (produced by GrafTech International Ltd.) having a thickness of 0.13 mm, a length of 30 mm, a width of 60 mm and thermal conductivities in the thickness direction of 7 W/mK and in a direction parallel to the surface of 240 W/mK.

The obtained heat radiation member 10 was placed on a ceramic heater (micro-ceramic heater MS-3 produced by SAKAGUCHI E.H VOC CORP., heat value: 9 W) as an exothermic part in such a manner that the thermally conductive polymer layer 2 came into contact with the ceramic heater. And then the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 65.2°C and the temperature t2 was 35.1°C. The obtained heat radiation member was soft and easy to handle at the time of mounting and had excellent repairability.

### (Example 2)

Firstly, 120 parts by weight of graphitized carbon fibers (produced by Nippon Graphite Fiber Corporation, average fiber diameter: 9 µm, average fiber length: 100 µm) and 100 parts by weight of aluminum oxide powders (produced by Showa Denko K.K., in spherical shape, average particle size: 3.5 µm) ) as thermally conductive fillers were mixed with 100 parts by weight of liquid silicone rubber (produced by GE Toshiba Silicone Co., Ltd.) as a polymer material 5. The resultant mixture was vacuum defoamed to prepare a thermally conductive polymer composition. Subsequently, this thermally conductive polymer composition was injected into a cavity of a mold having a shape corresponding to a predetermined sheet. A magnetic field (magnetic flux density of 10 tesla) was applied in such a manner that direction of the lines of magnetic force corresponded to the thickness direction of the thermally conductive polymer composition in the cavity. Thereby, the graphitized carbon fibers in the thermally conductive polymer composition molded into a sheet were oriented in the thickness direction. While this orientation of the graphitized carbon fibers was maintained, the thermally conductive composition was thermally cured to obtain thermally conductive polymer layer 2 in a sheet having a thickness of 0.15 mm, a length of 10 mm, and a width of 10 mm (hardness of 35). The graphitized carbon fibers contained in the obtained thermally conductive polymer layer 2 were oriented in such a manner that the fiber axes were substantially aligned in the thickness direction of the sheet. The thermal conductivities of the thermally conductive polymer layer 2 were measured in the same manner as in Example 1. The thermal conductivities in the thickness direction and the direction parallel to the surface of the thermally conductive polymer layer 2 were 11.2 W/mK and 3.1 W/mK, respectively. This sheet-like thermally conductive polymer layer 2 was joined onto a graphite sheet (produced by GrafTech International Ltd.) as a thermal diffusion sheet 1 by pressure bonding to produce a heat radiation member 10. The graphite sheet had a thickness of 0.13 mm, a length of 30 mm, a width of 60 mm and thermal conductivities in the thickness direction of 7 W/mK and in a direction parallel to the surface of 240 W/mK).

The obtained heat radiation member 10 was placed on a ceramic heater (micro-ceramic heater MS-3 produced by SAKAGUCHI E.H VOC CORP., heat value: 9 W) as an exothermic part in such a manner that the thermally conductive polymer layer 2 came into contact with the ceramic heater like Example 1. And then the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 51.4°C and the temperature t2 was 48.1°C. The obtained heat radiation member was soft and easy to handle at the time of mounting and had excellent repairability.

### (Comparative Example 1)

The same thermally conductive composition as used in Example 2 was prepared. Using this composition, a sheet-like thermally conductive polymer layer was produced in the same manner as in Example 2 except that a magnetic field was not applied when the thermally conductive polymer composition was cured. The graphitized carbon fibers contained in the thermally conductive polymer layer were not oriented. The thermal conductivities in the thickness direction and the direction parallel to the surface of this thermally conductive polymer layer were measured in the same manner as in Example 1. The thermal conductivities in the thickness direction and in a direction parallel to the surface of the thermally conductive polymer layer 2 were 2.4 W/mK and 3.5 W/mK, respectively. This sheet-like thermally conductive polymer layer was joined onto a graphite sheet (produced by GrafTech International Ltd.) as thermal diffusion sheet 1 to produce a heat radiation member. The graphite sheet had a thickness of 0.13 mm, a length of 30 mm, a width of 60 mm and thermal conductivities in the thickness direction of 7 W/mK and in a direction parallel to the surface of 240 W/mK).

The obtained heat radiation member was placed on a ceramic heater (micro-ceramic heater MS-3 produced by SAKAGUCHI E.H VOC CORP., heat value: 9 W) as an exothermic part in such a manner that the thermally conductive polymer layer came into contact with the ceramic heater as in Example 1. And then the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 77.5°C and the temperature t2 was 28.7°C.

### (Example 3)

Firstly, 140 parts by weight of scaly hexagonal boron nitride powders (available from GE Specialty Materials Japan Co., Ltd., average particle size: 7 to 10 µm, surface area: 13 m²/g) and 80 parts by weight of aluminum oxide powders (produced by Showa Denko K.K., in spherical shape, average particle size: 3.5 µm) as thermally conductive fillers were mixed with 100 parts by weight of liquid silicone rubber (produced by GE Toshiba Silicone Co., Ltd.) as a polymer material 5. The resultant mixture was vacuum defoamed to prepare a thermally conductive polymer composition. Subsequently, a mold in a frame form having a cavity corresponding to the shape of a desired thermally conductive polymer layer was installed on a graphite sheet having a thickness of 0.13 mm, a length of 30 mm, and a width of 60 mm and covered with a 16 µm-thick aluminum foil on both sides (produced by GrafTech International Ltd.) as a thermal diffusion sheet 1. The graphite sheet had thermal conductivities in the thickness direction of 7 W/mK and in a direction parallel to the surface of 240 W/mK, and 6 µm-thick acrylic pressure sensitive adhesive layer formed on the surface. The thermally conductive polymer composition was injected into a cavity arranged on the graphite sheet. A magnetic field (magnetic flux density of 10 tesla) was applied in such a manner that the direction of the lines of magnetic force corresponded to the thickness direction of the thermally conductive polymer composition molded into a sheet form to orient the hexagonal boron nitride powders in the thermally conductive polymer composition. While this orientation of the hexagonal boron nitride was maintained, the thermally conductive composition was thermally cured to obtain a heat radiation member 20 including a thermally conductive polymer layer 2 (JIS type A hardness of 36) having a thickness of 0.15 mm, a length of 10 mm, and a width of 10 mm formed on the graphite sheet. The hexagonal boron nitride powders contained in the obtained thermally conductive polymer layer 2 were oriented in such a manner that the surface of each scaly particle is aligned along the thickness direction of the sheet. The thermal conductivities of the thermally conductive polymer layer 2 were measured in the same manner as in Example 1. The thermal conductivities in the thickness direction and the direction parallel to the surface of the thermally conductive polymer layer 2 were 2.7 W/mK and 1.6 W/mK, respectively.

The obtained heat radiation member 10 was placed on a ceramic heater (micro-ceramic heater MS-3 produced by SAKAGUCHI E.H VOC CORP., heat value: 9 W) as an exothermic part in such a manner that the thermally conductive polymer layer 2 came into contact with the ceramic heater as in Example 1. And then the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 70.5°C and the temperature t2 was 29.6°C. The obtained heat radiation member was soft and easy to handle at the time of mounting and had excellent repairability.

### (Comparative Example 2)

The same thermally conductive composition as in Example 3 was prepared to produce a heat radiation member in the same manner as in Example 3 except that a magnetic field was not applied when the thermally conductive polymer composition was cured. The hexagonal boron nitride powders contained in this thermally conductive polymer layer were not oriented. The thermal conductivities of the thermally conductive polymer layer were measured in the same manner as in Example 1. The thermal conductivities in the thickness direction and in a direction parallel to the surface of the thermally conductive polymer layer 2 were 1.8 W/mK and 2.4 W/mK, respectively.

The obtained heat radiation member was placed on a ceramic heater (micro-ceramic heater MS-3 produced by SAKAGUCHI E.H VOC CORP., heat value: 9 W) as an exothermic part in such a manner that the thermally conductive polymer layer came into contact with the ceramic heater as in Example 3. And then the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 81.7°C and the temperature t2 was 24.3°C.

### (Example 4)

40 parts by weight of graphitized carbon fibers (produced by Nippon Graphite Fiber Corporation, average fiber diameter: 9 µm, average fiber length: 100 µm), 80 parts by weight of aluminum oxide powders (produced by Showa Denko K.K., in spherical shape, average particle size: 10 µm), and 20 parts by weight of monocrystalline aluminum oxide powders (produced by Showa Denko K.K., average particle size: 2 µm) as thermally conductive fillers were mixed with 100 parts by weight of epoxy resin (produced by Three Bond Co., Ltd.) being an adhesive resin. The resultant mixture was vacuum defoamed to prepare a thermally conductive polymer composition. Subsequently, a mold in a frame form having a cavity corresponding to the shape of a desired thermally conductive polymer layer was placed on a thermal diffusion sheet 1. The thermal diffusion sheet 1 used was a graphite sheet having a thickness of 0.13 mm, a length of 30 mm, and a width of 60 mm and entirely covered with a 16 µm-thick aluminum foil (produced by GrafTech International Ltd., thermal conductivity in the thickness direction: 7 W/mK, thermal conductivity in a direction parallel to the surface: 240 W/mK, and 6 µm-thick acrylic pressure-sensitive adhesive layer formed on the surface). The thermally conductive polymer composition was injected into a cavity arranged on the graphite sheet.

A magnetic field (magnetic flux density of 10 tesla) was applied in such a manner that the direction of the lines of magnetic force corresponded to the thickness direction of the thermally conductive polymer composition molded into a sheet to align the graphitized carbon fibers contained in the thermally conductive polymer composition such that their fiber axes were aligned substantially parallel to the thickness direction of the sheet. While this orientation of the graphitized carbon fibers was maintained, the thermally conductive composition was heated to be semi-cured into the B stage state to obtain a heat radiation member including an adhesive thermally conductive polymer layer 2 on the graphite sheet. The graphitized carbon fibers contained in the obtained thermally conductive polymer layer 2 were oriented in the thickness direction. When the thermal conductivities of the thermally conductive polymer layer 2 were measured in the same manner as in Example 1. The thermal conductivities in the thickness direction and is a direction parallel to the surface of the thermally conductive polymer layer 2 were 6.5 W/mK and 2.3 W/mK, respectively.

The obtained heat radiation member 10 was placed on a ceramic heater (micro-ceramic heater MS-3 produced by SAKAGUCHI E.H VOC CORP., heat value: 9 W) as an exothermic part in such a manner that the thermally conductive polymer layer 2 came into contact with the ceramic heater. And then the thermally conductive polymer layer 2 was fully cured by heating and then cooled to room temperature. Thereafter, the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 63.7°C and the temperature t2 was 31.3°C. The obtained heat radiation member was not dislocated with respect to the exothermic part (ceramic heater) during the thermally conductive polymer layer 2 was fully cured on the exothermic part. Further, the thermally conductive polymer layer 2, after fully cured, had excellent adhesion to the graphite sheet.

### (Comparative Example 3)

The same thermally conductive composition as in Example 4 was prepared. A heat radiation member was produced in the same manner as in Example 4 except that a magnetic field was not applied when the thermally conductive polymer composition was cured. The graphitized carbon fibers contained in this thermally conductive polymer layer were not oriented. The thermal conductivities of this thermally conductive polymer layer were measured in the same manner as in Example 1. The thermal conductivities in the thickness direction and in a direction parallel to the surface of the thermally conductive polymer layer 2 were 1.9 W/mK and 2.5 W/mK, respectively.

The obtained heat radiation member was placed on a ceramic heater (micro-ceramic heater MS-3 produced by SAKAGUCHI E.H VOC CORP., heat value: 9 W) as an exothermic part in such a manner that the thermally conductive polymer layer came into contact with the ceramic heater. Then, the thermally conductive polymer layer was fully cured by heating and then cooled into the room temperature. Thereafter, the ceramic heater was powered-on. After ten minutes, the temperature t1 at the center portion of the top surface (10 mm x 10 mm) of the ceramic heater and the temperature t2 at the peripheral portion of the thermal diffusion sheet 1 of the heat radiation member (interval between the measurement positions of the temperatures t1 and t2: 40 mm) were measured. The temperature t1 was 81.2°C and the temperature t2 was 24.5°C.

The present examples and embodiments are to be considered as illustrative and not restrictive and the invention is not to be limited to the details given herein, but may be modified within the scope and equivalence of the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A heat radiation member (10, 20) **characterized by:**
a thermal diffusion sheet (1); and
a thermally conductive polymer layer (2) provided on at least a part of the thermal diffusion sheet (1), wherein thermal conductivity of the thermally conductive polymer layer (2) in a thickness direction of the layer (2) is higher than thermal conductivity of the thermally conductive polymer layer (2) in a direction parallel to the surface of the layer (2).

2. The heat radiation member (10, 20) according to claim 1, **characterized in that:** the thermal conductivity of the thermally conductive polymer layer (2) in the thickness direction of the layer (2) is higher than thermal conductivity of the thermal diffusion sheet (1) in a thickness direction of the sheet.

3. The heat radiation member (10, 20) according to claims 1 or 2, **characterized in that**: the thermally conductive polymer layer (2) contains a polymer material (5) and at least one type of thermally conductive filler (3, 4) selected from carbon fibers, carbon nanotubes, metal nitrides, metal oxides, metal carbides and metal hydroxides; wherein the thermally conductive filler (3, 4) is oriented in a specific direction in the thermally conductive polymer layer (2).

4. The heat radiation member (10, 20) according to claim 3, **characterized in that:** the thermally conductive filler (3, 4) comprises carbon fibers.

5. The heat radiation member (10, 20) according to claim 3, **characterized in that**: the thermally conductive filler (3, 4) comprises hexagonal a boron nitride powder.

6. The heat radiation member (10, 20) according to any one of preceding claims, **characterized in that:** the thermally conductive polymer layer (2) has a hardness of 60 or less.

7. The heat radiation member (10, 20) according to any one of claims 3 to 6, **characterized in that:** the polymer material (5) in the thermally conductive polymer layer (2) has been fully cured.

8. The heat radiation member (10, 20) according to any one of claims 3 to 5, **characterized in that**: the polymer material (5) in the thermally conductive polymer layer (2) has been semi-cured.

9. The heat radiation member (10, 20) according to claim 8, **characterized in that:** the polymer material (5) in the thermally conductive polymer layer (2) comprises an adhesive resin.

10. The heat radiation member (10, 20) according to any one of preceding claims, **characterized in that**: the thermal diffusion sheet (1) is one of a graphite sheet and a composite sheet including a graphite sheet (1b) and an aluminum foil (1a, 1c) provided on the graphite sheet.

11. A method for producing a heat radiation member (10, 20) including a thermal diffusion sheet (1) and a thermally conductive polymer layer (2) provided on at least a part of the thermal diffusion sheet (1), **characterized by:**
independently forming the thermally conductive layer (2) in a sheet from a thermally conductive polymer composition containing thermal conductive filler(3, 4), wherein the thermal conductive filler (3, 4) in the layer (2) is oriented in a specific direction such that thermal conductivity of the thermally conductive polymer layer (2) in a thickness direction of the layer (2) becomes higher than thermal conductivity of the thermally conductive polymer layer (2) in a direction parallel to the surface of the layer (2); and
joining the formed thermally conductive layer (2) onto at least a part of the thermal diffusion sheet (1).

12. A method for producing a heat radiation member (10, 20) including a thermal diffusion sheet (1) and a thermally conductive polymer layer (2) provided on at least a part of the thermal diffusion sheet (1), **characterized by:**
placing a thermally conductive polymer composition containing a thermal conductive filler (3, 4) onto at least a part of the thermal diffusion sheet (1);
orienting the thermally conductive filler (3, 4) in a specific direction such that thermal conductivity of the thermally conductive polymer layer (2) to be obtained in a thickness direction of the layer (2) becomes higher than thermal conductivity of the thermally conductive polymer layer (2) in a direction parallel to the surface of the layer (2); and
curing the thermally conductive polymer composition, while the orientation of the thermally conductive filler (3, 4) is maintained, to form the thermally conductive layer (2) on the thermal diffusion sheet (1).

13. The method according to claims 11 or 12 **characterized in that:** the orientation of the thermally conductive filler (3, 4) is performed by an application of one of an electric field and a magnetic field.
